# EUROPÄISCHE PATENTSCHRIFT

(11) **EP 0 821 472 B1**
(45) Veröffentlichungstag und Bekanntmachung des Hinweises auf die Patenterteilung: **21.11.2001**
(21) Anmeldenummer: 97110151.4
(22) Anmeldetag: 20.06.1997
(51) Int. Cl.: H03F 1/30, H03F 3/45

(54) **Schaltungsanordnung zur Einstellung des Arbeitspunktes**
Circuit device for adjusting the operating point
Dispositif de circuit pour l'ajustement du point de fonctionnement

(30) Priorität: 23.07.1996 DE 19629769
(43) Veröffentlichungstag der Anmeldung: 28.01.1998
(73) Patentinhaber: Infineon Technologies AG, 81669 München (DE)
(72) Erfinder: Weber, Stephan, 81739 München (DE)
(74) Vertreter: Zedlitz, Peter, Dipl.-Inf.

(56) Entgegenhaltungen:
- EP-A- 0 600 141
- GB-A- 2 256 336
- US-A- 2 991 424
- US-A- 5 329 115
- DUNCAN B: "CMR UNDER TEST" ELECTRONICS WORLD AND WIRELESS WORLD, Bd. 100, Nr. 1700, Seiten 540-546, XP000459731

## Beschreibung

Die Erfindung betrifft eine Schaltungsanordnung zur Einstellung des Arbeitspunktes mindestens eines durch Wechselsignale angesteuerten Signaltransistors.

Eine derartige Schaltungsanordnung ist beispielsweise aus der DE 38 11 949 A1 bekannt.

Insbesondere bei im Hochfrequenzbereich arbeitenden Schmalband-Leistungsverstärkern sollte der Arbeitspunkt der verwendeten Transistoren möglichst optimal eingestellt werden, um einen hohen Wirkungsgrad und ein gutes Oberwellenverhalten dieser Verstärker zu erhalten. Darüber hinaus sollte für das Einstellen des Arbeitspunktes zum Zwecke eines höheren Wirkungsgrades keine Signalenergie verbraucht werden und die Einstellung weitgehend exemplarunabhängig sein.

Zur Entkopplung der Arbeitspunkteinstellung vom Nutzsignal wird üblicherweise eine Induktivität bzw. eine λ/4-Leitung eingesetzt. Bei teilweiser oder vollständiger Integration der Verstärkerschaltung werden in diesem Fall entweder zusätzliche Anschlüsse beim jeweiligen integrierten Schaltkreis oder aber zusätzliche Chipfläche benötigt. Bei Gegentaktverstärkern werden zwei identische Arbeitspunkteinstellungen vorgenommen, wobei sich der Platzbedarf aufgrund zweier Induktivitäten bzw. λ/4-Leitungen gegenüber der eintaktigen Ausführung praktisch verdoppelt.

Aufgabe der Erfindung ist es, eine Schaltungsanordnung zur Einstellung des Arbeitspunktes mindestens eines durch Wechselsignale angesteuerten Signaltransistors anzugeben, die diese Nachteile nicht aufweist.

Die Aufgabe wird durch eine Schaltungsanordnung gemäß Patentanspruch 1 gelöst. Weiterbildungen des Erfindungsgedankens sind Gegenstand von Unteransprüchen.

Bei der erfindungsgemäßen Schaltungsanordnung erfolgt die Einstellung des Arbeitspunktes eines durch Wechselsignale angesteuerten Signaltransistors mittels einer Stromquelle, die einerseits mit einem Versorgungspotential und andererseits mit dem Steuereingang -beispielsweise der Basis- des Signaltransistors gekoppelt ist, mittels eines Stelltransistors, dessen Laststrecke -beispielsweise dessen Emitter-Kollektor-Strecke- einerseits mit einem Bezugspotential und andererseits mit dem Steuereingang des Signaltransistors gekoppelt ist, mit einem Widerstand, der einerseits mit dem Steuereingang -beispielsweise der Basis- des Stelltransistors und andererseits mit dem Stelleingang des Signaltransistors verbunden ist, und mittels einer Kapazität, die zwischen den Steuereingang des Stelltransistors und das Bezugspotential geschaltet ist. Der Signaltransistor ist dabei ein beispielsweise in einer Verstärkerstufe enthaltener Transistor, über den ein zu bearbeitendes, also beispielsweise zu verstärkendes Signal geführt wird. Dessen Arbeitspunkt wird unter anderem mittels des Stelltransistors eingestellt. Als Transistoren finden dabei im Hochfrequenzbereich bevorzugt Bipolartransistoren Verwendung, es können jedoch dem jeweiligen Anwendungsfall entsprechend aber auch MOS-Transistoren in gleicher Weise verwendet werden. Vorteilhaft ist insbesondere, daß neben Widerständen und Transistoren auch eine leicht zu integrierende Kapazität Verwendung findet, die gegenüber λ/4-Leitungen relativ klein bemessen ist und daher weniger Chipfläche beansprucht.

Bei einer Gegentaktausführung ist ein weiterer Signaltransistor vorgesehen, dessen Arbeitspunkteinstellung durch eine weitere Stromquelle, die einerseits mit dem Versorgungspotential und andererseits mit dem Steuereingang des weiteren Signaltransistors gekoppelt ist, durch einen weiteren Stelltransistor, dessen Laststrecke einerseits mit einem Bezugspotential und andererseits mit dem Steuereingang des weiteren Signaltransistors gekoppelt ist, durch einen weiteren Widerstand, der einerseits mit dem Steuereingang des weiteren Stelltransistors und andererseits mit dem Stelleingang des weiteren Stelltransistors verbunden ist, erfolgt, wobei der Steuereingang des weiteren Stelltransistors mit dem Steuereingang des Stelltransistors verbunden ist. Vorteilhafterweise wird bei einer differenziellen Signalführung keine weitere Kapazität benötigt, so daß sich die Chipfläche durch die zusätzlichen Widerstände und Transistoren nur geringfügig erhöht.

Schließlich kann vorgesehen werden, daß zwischen den Steuereingang des Signaltransistors einerseits und den Knotenpunkt von Stromquelle, Widerstand und Stelltransistors andererseits ein Koppelwiderstand geschaltet ist und/oder daß zwischen den Steuereingang des weiteren Signaltransistors einerseits und den Knotenpunkt von weiterer Stromquelle, weiterem Widerstand und weiterem Stelltransistor andererseits ein weiterer Koppelwiderstand geschaltet ist.

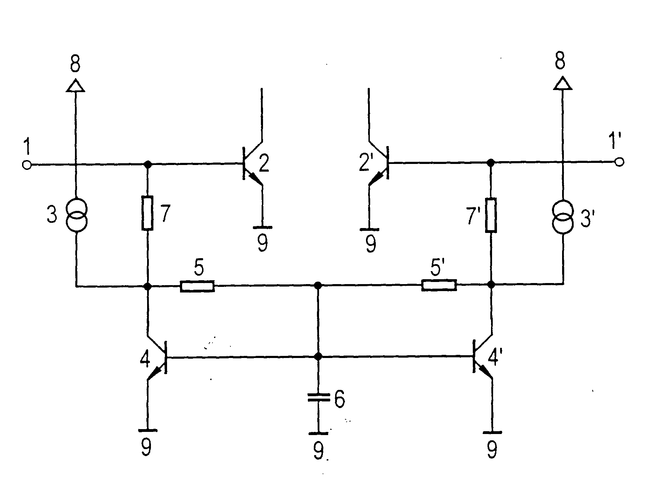

Die Erfindung wird nachfolgend anhand des in der einzigen Figur der Zeichnung dargestellten Ausführungsbeispiels näher erläutert.

Beim Ausführungsbeispiel sind zwei Signaltransistoren 2, 2', vorgesehen, die beispielsweise Teil einer Verstärkerschaltung für höhere Frequenzen sind. Die Kollektoren der beiden Transistoren 2 und 2' führen folglich zu weiteren, in der Zeichnung jedoch nicht dargestellten Schaltungsteilen. Ihre Emitter sind dabei direkt mit einem Bezugspotential 9 verbunden. Sie könnten jedoch auch in gleicher Weise über andere Schaltelemente wie beispielsweise Widerstände mit dem Bezugspotential 9 gekoppelt sein. Die Ansteuerung der Transistoren 2 und 2' erfolgt mittels eines differenziellen Signals, das durch zwei zueinander inverse Signale 1 und 1' gebildet wird. Die Basen der Transistoren 2 und 2' sind desweiteren über jeweils einen Koppelwiderstand 7 bzw. 7' mit jeweils einem Knotenpunkt verbunden, der unter anderem mit dem Kollektor jeweils eines npn-Transistors 4 bzw. 4' verschaltet ist. Die Kollektoren der Transistoren 4 und 4' sind darüber hinaus über jeweils eine Stromquelle 3 bzw. 3' mit einem Versorgungspotential 8 gekoppelt sowie über jeweils einen Widerstand 5 bzw. 5' mit den miteinander verschalteten Basen der Transistoren 4 und 4' gekoppelt. Die miteinander verschalteten Basen der Transistoren 4 und 4' sind darüber hinaus über eine Kapazität 6 mit dem Bezugspotential 9 verbunden, an das auch die Emitter der Transistoren 4 und 4' angeschlossen sind.

Bei differenziellen Schaltungen wie beispielsweise Gegentaktverstärkern besteht der Unterschied zwischen der Gleichstromarbeitspunkteinstellung und der Signalverarbeitung nicht nur in der Frequenz, sondern auch darin, daß es sich beim Nutzsignal um ein Gegentaktsignal handelt und die Arbeitspunkteinstellung als Gleichtaktsignal anzusehen ist. Die erfindungsgemäße Schaltungsanordnung ermöglicht es bei Gegentaktschaltungen eine Gleichstromzuführung ohne Spule bzw. λ/4-Leitung. Dabei bleiben die Vorteile einer induktiven Lösung wie geringe Signalverluste weitgehend erhalten, jedoch wird nur ein Bruchteil der Fläche bei einer integrierten Ausführung benötigt. Bei symmetrischer Ausführung werden aufgrund der Gegentaktansteuerung mit dem Nutzsignal die Schaltungskrioten an den Basen der Stelltransistoren 4 und 4', also an deren Steuereingängen, nicht angesteuert, da der Kondensator 6 an den Steuereingängen der Transistoren 4 und 4' für Wechselsignale einen virtuellen Nullpunkt erzeugt. Dadurch werden die Transistoren 4 und 4' durch Wechselsignale nicht ausgesteuert und wirken deshalb als Stromquellen. Demzufolge beeinflussen sie den Signalweg an den Basen, also an den Steuereingängen der Transistoren 2 und 2' nicht. Bei Gleichströmen arbeitet die Schaltung dagegen wie zwei unabhängige Stromspiegel, wodurch sich eine weitgehende Exemplarunabhängigkeit realisieren läßt.

Damit sich parasitäre Eigenschaften, wie beispielsweise Transistorkapazitäten, möglichst wenig auswirken, können die Widerstände 5 und 5' durch mehrere in Serie geschaltete einzelne Widerstände gebildet werden. Ebenso kann die endliche Stromverstärkung weitgehend kompensiert werden, indem zusätzliche Basiswiderstände in die Basisleitung der Stelltransistoren 4 und 4' geschaltet werden. Darüber hinaus kann wie bei jedem anderen Stromspiegel auch das Emitter-Flächenverhältnis ungleich 1 gewählt werden. Schließlich kann der Kondensator 6 derart bemessen werden, daß die Wirkung der Gleichtakt-Gegenkopplung bereits bei niedrigen Frequenzen aufgehoben wird. Dies kann beispielsweise bei sehr hohen Signalfrequenzen vorteilhaft sein, da sich hier die Transistoren nicht mehr ideal verhalten.

Abschließend sei darauf hingewiesen, daß neben der als Ausführungsbeispiel gezeigten symmetrischen Ausführung in gleicher Weise auch eine unsymmetrische Ausführung möglich ist. Dazu sind beim vorliegenden Ausführungsbeispiel lediglich die Schaltungselemente 1' bis 7' zu entfernen.

## Patentansprüche

1. Schaltungsanordnung zur Einstellung des Arbeitspunktes mindestens eines durch Wechselsignale (1) angesteuerten Signaltransistors (2) mit einer Stromquelle (3), die einerseits mit einem Versorgungspotential (8) und andererseits mit dem Steuereingang des Signaltransistors (2) gekoppelt ist, mit einem Stelltransistor (4), dessen Laststrecke einerseits mit einem Bezugspotential (9) und andererseits mit dem Steuereingang des Signaltransistors (2) gekoppelt ist, mit einem Widerstand (5), der einerseits mit dem Steuereingang des Stelltransistors (4) und andererseits mit dem Steuereingang des Signaltransistors (2) verbunden ist, und mit einer Kapazität (6), die zwischen den Steuereingang des Stelltransistors (4) und das Bezugspotential (9) geschaltet ist, und mit einem weiteren durch inverse Wechselsignale (1') angesteuerten Signaltransistor (2'), mit einer weiteren Stromquelle (3'), die einerseits mit dem Versorgungspotential (8) und andererseits mit dem Steuereingang des weiteren Signaltransistors (2') gekoppelt ist, mit einem weiteren Stelltransistor (4'), dessen Laststrecke einerseits mit dem Bezugspotential (9) und andererseits mit dem Steuereingang des weiteren Signaltransistors (2') gekoppelt ist, mit einem weiteren Widerstand (5'), der einerseits mit dem Steuereingang des weiteren Stelltransistors (4') und
andererseits mit dem Steuereingang des weiteren Signaltransistors (2') verbunden ist, wobei der Steuereingang des weiteren Stelltransistors (4') mit dem Steuereingang des Stelltransistors (4) direkt verbunden ist.

2. Schaltungsanordnung nach Anspruch 1,
**dadurch gekennzeichnet, daß** zwischen den Steuereingang des Signaltransistors (2) einerseits und den Knotenpunkt von Stromquelle (3), Widerstand (5) und Stelltransistor (4) andererseits ein Koppelwiderstand (7) geschaltet ist, und daß zwischen den Steuereingang des weiteren Signaltransistors (2') einerseits und den Knotenpunkt von weiterer Stromquelle (3'), weiterem Widerstand (5') und weiterem Stelltransistor (4') andererseits ein weiterer Koppelwiderstand (7') geschaltet ist.

## Claims

1. Circuit arrangement for setting the operating point of at least one signal transistor (2) which is actuated by alternating signals (1), having a current source (3) which is coupled firstly to a supply potential (8) and secondly to the control input of the signal transistor (2), having a control transistor (4) whose load path is coupled firstly to a reference-earth potential (9) and secondly to the control input of the signal transistor (2), having a resistor (5) which is connected firstly to the control input of the control transistor (4) and secondly to the control input of the signal transistor (2), and having a capacitance (6) which is connected between the control input of the control transistor (4) and the reference-earth potential (9), and
having a further signal transistor (2'), which is actuated by inverse alternating signals (1'), having a further current source (3') which is coupled firstly to the supply potential (8) and secondly to the control input of the further signal transistor (2'), having a further control transistor (4') whose load path is coupled firstly to the reference-earth potential (9) and secondly to the control input of the further signal transistor (2'), having a further resistor (5') which is connected firstly to the control input of the further control transistor (4') and secondly to the control input of the further signal transistor (2'), with the control input of the further control transistor (4') being connected directly to the control input of the control transistor (4).

2. Circuit arrangement according to Claim 1,
**characterized in that** a coupling resistor (7) is connected between the control input of the signal transistor (2) on one side and the node of the current source (3), the resistor (5) and the control transistor (4) on the other side, and **in that** a further coupling resistor (7') is connected between the control input of the further signal transistor (2') on one side and the node of the further current source (3'), the further resistor (5') and the further control transistor (4') on the other side.

## Revendications

1. Dispositif de circuit pour l'ajustement du point de fonctionnement d'au moins un transistor de signalisation (2) commandé par des signaux alternatifs (1) avec une source de courant (3) qui est couplée, d'une part, à un potentiel d'alimentation (8) et, d'autre part, à l'entrée de commande du transistor de signalisation (2), avec un transistor de réglage (4), dont la voie de charge est couplée, d'une part, à un potentiel de référence (9) et, d'autre part, à l'entrée de commande du transistor de signalisation (2),
avec une résistance (5), qui est reliée, d'une part, à l'entrée de commande du transistor de réglage (4) et, d'autre part, à l'entrée de commande du transistor de signalisation (2), et avec une capacité (6) qui est mise en circuit entre l'entrée de commande du transistor de réglage (4) et le potentiel de référence (9), et
avec un autre transistor de signalisation (2') commandé par des signaux alternatifs inverses (1'), avec une autre source de courant (3'), qui est couplée d'une part au potentiel d'alimentation (8) et, d'autre part, à l'entrée de commande de l'autre transistor de signalisation (2'), avec un autre transistor de réglage (4') dont la voie de charge est couplée, d'une part, au potentiel de référence (9) et, d'autre part, à l'entrée de commande de l'autre transistor de signalisation (2'), avec une autre résistance (5') qui est reliée, d'une part, à l'entrée de commande de l'autre transistor de réglage (4') et, d'autre part, à l'entrée de commande de l'autre transistor de signalisation (2'), l'entrée de commande de l'autre transistor de réglage (4') étant reliée directement à l'entrée de commande du transistor de réglage (4).

2. Dispositif de circuit selon la revendication 1, **caractérisé en ce qu'**entre l'entrée de commande du transistor de signalisation (2), d'une part, et le point noeudal de la source de courant (3), la résistance (5) et le transistor de réglage (4), d'autre part, est couplée une résistance de connexion (7), et **en ce qu'**entre l'entrée de commande de l'autre transistor de signalisation (2'), d'une part, et le point noeudal de l'autre source de courant (3'), d'une autre résistance (5') et d'un autre transistor de réglage (4'), d'autre part, est couplée une autre résistance de connexion (7').
